Europäisches Patentamt

European Patent Office

Office européen des brevets

(19)

(11) Publication number: **0 192 108 B1**

(12) **EUROPEAN PATENT SPECIFICATION**

(45) Date of publication of patent specification: **17.06.92**

(51) Int. Cl.⁵: **G05B 19/04**, H05K 7/00, H04B 5/00, G02B 7/00, H01F 23/00

(21) Application number: **86101333.2**

(22) Date of filing: **01.02.86**

(54) **Control station.**

(30) Priority: **11.02.85 US 700456**

(43) Date of publication of application:
**27.08.86 Bulletin 86/35**

(45) Publication of the grant of the patent:
**17.06.92 Bulletin 92/25**

(84) Designated Contracting States:
**AT BE CH DE FR GB IT LI LU NL SE**

(56) References cited:
EP-A- 0 033 445   EP-A- 0 063 626
WO-A-80/00381   DE-A- 3 027 078
FR-A- 2 548 511   FR-A- 2 566 572

**ADVANCES IN INSTRUMENTATION, vol. 39, part 1, 22nd-25th October 1984, pages 393-407, Research Triangle Park, North Carolina, US; K. Inoh et al.: "Highly reliable, high-speed multi-purpose optical fiber communication data link"**

(73) Proprietor: **Lovrenich, Rodger T.**
**209 Whispering Sands**
**Santa Teresa New Mexico 88008(US)**

(72) Inventor: **Lovrenich, Rodger T.**
**209 Whispering Sands**
**Santa Teresa New Mexico 88008(US)**

(74) Representative: **Wehnert, Werner et al**
**Patentanwälte Dipl.-Ing. Hauck, Dipl.-Phys. Schmitz, Dipl.-Ing. Graalfs, Dipl.-Ing. Wehnert, Dipl.-Phys. Carstens, Dr.-Ing. Döring**
**Mozartstrasse 23**
**W-8000 München 2(DE)**

Rank Xerox (UK) Business Services

EP 0 192 108 B1

## Description

The present invention relates to a control station according to the preamble of claim 1 or, respectively, claim 7.

## Background of the Invention

The invention will be described in relation to a work station control system of an automated production line known as a "transfer line" wherein the work station is one of several work stations that communicate with each other and with an orchestrater computer on an optical communication loop. Typical computerized work stations in an industrial transfer line use substantial quantities of hard wiring at high material and labor cost. In addition, such wiring is subject to electrical and magnetic interference in less than ideal surroundings, and suffers a high failure rate because of the number of electrical terminations. Plug-in electrical connections such as edge connectors substantially increase the possibility of failure. Filters are used to suppress unwanted noise and potting is employed to shield the devices mechanically, but known systems do not include sufficient electrical and mechanical isolation. Diagnosis of system failure is a complex and time-consuming task. Repair is costly because maintenance personnel must execute antiquated diagnostic procedures. Insufficient thought has been given to providing a system construction that substantially reduces down-time and in-situ repairs.

According to a known structure (WO-A-8000381) a control station comprises an input/output rack assembly with a base on a cover as support structure, logic input/output modules including means for removeably mounting said logic module means to said support structure and means for transmitting communication signals on lines to and from said logic module logic module means for conducting controlled operations at said station. The said transmission means are defined by physical connections such as plug connectors.

## Objects and Summary of the Invention

The object of the present invention is to provide a control logic module and structure for coupling the same into a communications loop which include facility for contactless coupling of power and communication signals to and from the logic module as well as station character identifying signals to the logic module.

The object stated is solved by the features of claim 1 or, respectively, claim 7. An advantage of the invention is to provide a logic module and coupling structure of the described character which include facility for rapid and easy replacement of defective modules so as to reduce down-time of the overall system.

Yet another and more specific advantage of the invention is to provide a logic module and coupling structure of the described character wherein the logic modules are essentially interchangable and wherein the coupling structure includes facility for identifying location of each logic module in the communications loop.

A preferred embodiment of the present invention includes a logic module for generating and receiving optical communication signals. The logic module is removably mounted in support structure and is magnetically coupled to a power supply in the support structure. Input/output (I/O) elements are positioned in the support structure adjacent to the logic module and communicate with the logic module by optical coupling. The logic module is thus coupled with the I/O elements and with the power supply without electrical contacts. The construction can be used in industrial environments where dirt and magnetic and electrical noise are prevalent.

## Brief Description of the Drawings

In the drawings:

Figure 1 is a schematic of a work station with a control device constructed in accordance with the present invention shown connected to an orbital communication loop that contains other stations (not shown).

Figure 2 is a perspective view of the control device mounted in an enclosure with the enclosure door open.

Figure 3 is a fragmentary front view of the enclosure backplane with module removed showing the mounting and connection arrangement.

Figure 4 is a view of the logic module end which interconnects with the enclosure backplane of FIG. 3.

Figure 5 is an enlarged fragmentary sectional view taken along line 5-5 in Figure 3.

Figure 6 is a fragmentary sectional view taken on line 6-6 of Figure 5.

Figure 7 is a front view on an enlarged scale of an I/O module of FIG. 3.

Figure 8 is an enlarged side elevation view, with portions cut away, of the structure of Figure 3, showing the logic module being attached to the support frame.

Figure 9 is a sectional view taken on line 9-9 in Figure 8.

Figure 10 is a view similar to that of Figure 8 showing the logic module secured in place.

Figure 11 is a perspective view, partly sectioned, of the personality module used to identify the control station.

Figure 12 illustrates the attachment of the logic module to the backplane with the I/O modules in place.

Figure 13 illustrates the attachment of an I/O module to the backplane with the logic module in place.

Figure 14 is an enlarged fragmentary view of the power module of the present invention showing the indicator lights.

Figure 15A is a schematic diagram of an output embodiment of the I/O module.

Figure 15B is a schematic diagram of an input embodiment of the I/O module.

Figure 15C is a schematic diagram of an I/O module used with illuminated pushbuttons.

Figure 16 is a perspective view of a device used to test the apparatus of the present invention for error.

Figure 17 is a perspective view showing the test device of Figure 16 used in testing an I/O module.

Figure 18 is a functional block diagram of the work station system.

## Detailed Description of Preferred Embodiments

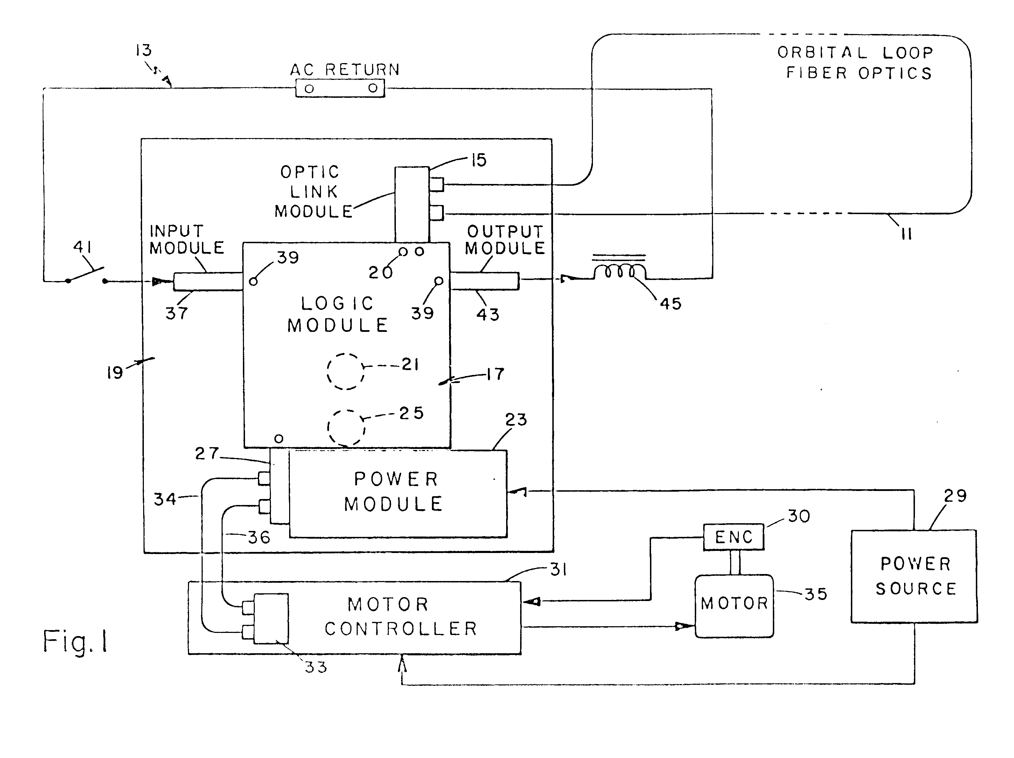

Figure 1 illustrates the use of the present invention in a distributed logic control system and communication loop. A fiber optic orbital loop 11 includes an orchestrater computer and a plurality of station computers that are not shown. Optical signals are transmitted and received on loop 11. A station 13 embodying the present invention includes a fiber optic line 15 that is optically coupled to the loop 11 for transmitting and receiving optical signals between loop 11 and station 13. Link 15 includes a watchdog relay (not shown) that can shut down the system if it detects an error.

A depluggable logic module 17, such as a computes or programmable controller, is connected to the backplane 19 that is contained in and forms part of the logic module mounting structure. Indicating lights 20 on logic module 17 show whether or not signals are passing between fiber optic link 15 and logic module 17. Logic module 17 includes a personality module 21 that identifies this particular work station, as explained later. A power module 23 is mounted on backplane 9 and is magnetically coupled to a coupling transformer 25 carried by logic module 17. Power module 23 is optically coupled to the logic module by the fiber optic link 27 and is connected to an a.c. power source 29. Power module 23 is also optically coupled to a motor controller 31 through fiber optic link 27 and the fiber optic link 33 via fiber optical cables 34 and 36. A motor controller 31 is connected to a.c.

power source 29 and to an electrical motor 35 that has an encoder 30 on its shaft.

An input module 37 (Figure 1) is carried by backplane 19 and is optically coupled to logic module 17. An output module 43 is carried by backplane 19 and optically coupled to logic module 17. Logic module 17 includes indicator lights 39 on its face adjacent to I/O modules 37, 43 to give a visual indication of whether or not signals are being transmitted between the logic module and the I/O modules. Input module 37 is electrically connected to an external sensor, such as a limit switch 41. When limit switch 41 is opened or closed, this condition is transmitted through input module 37 to logic module 17, and may be transmitted by logic module 17 onto orbital loop 11 through optical line 15. Output module 43 is electrically connected to an external device such as a solenoid 45 that may be used to operate a clamp (not shown). Closure of limit switch 41 may indicate that the clamp is closed, for example.

The orchestrater computer (not shown) may send an instruction on loop 11 to work station logic module 17 through optical link 15 telling the work station to carry out a program in the memory of logic module 17 that moves a clamp against a workpiece vise solenoid 45 and reports via limit switch 41 when the workpiece is clamped. This instruction may take the form of a binary word that is interpreted in the logic module to do certain things according to a table in logic module memory. Logic module 17 sends a signal through output module 43 to solenoid 45 that moves the clamp (not shown) to the engaged position. When the clamp is in the engaged position it closes limit switch 41, and this fact is reported back through input module 37 to logic module 17.

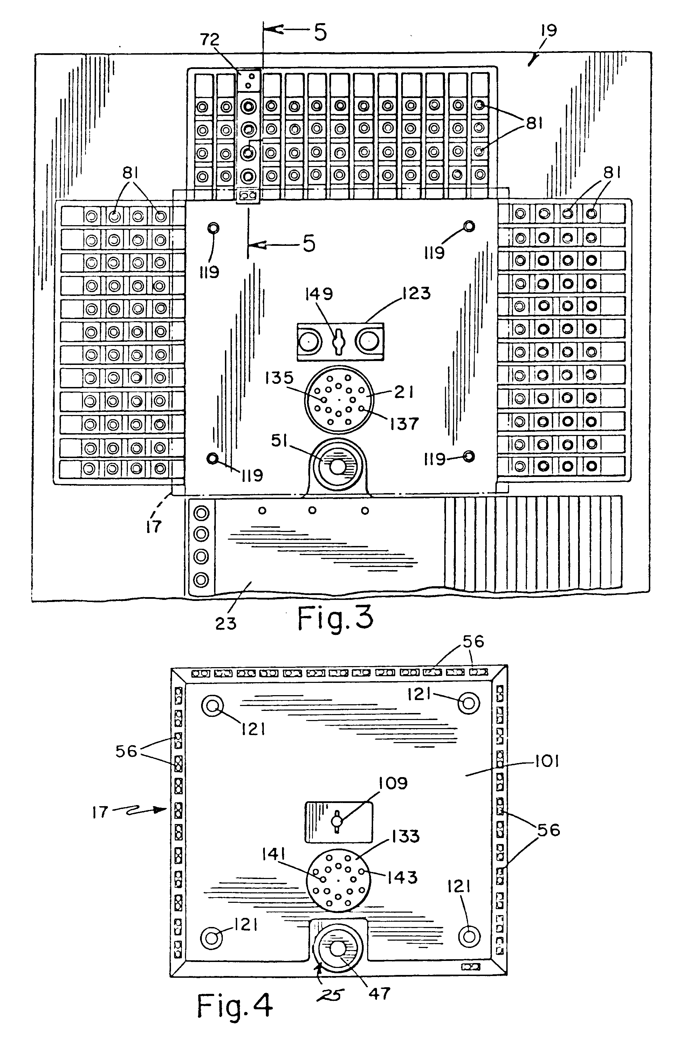

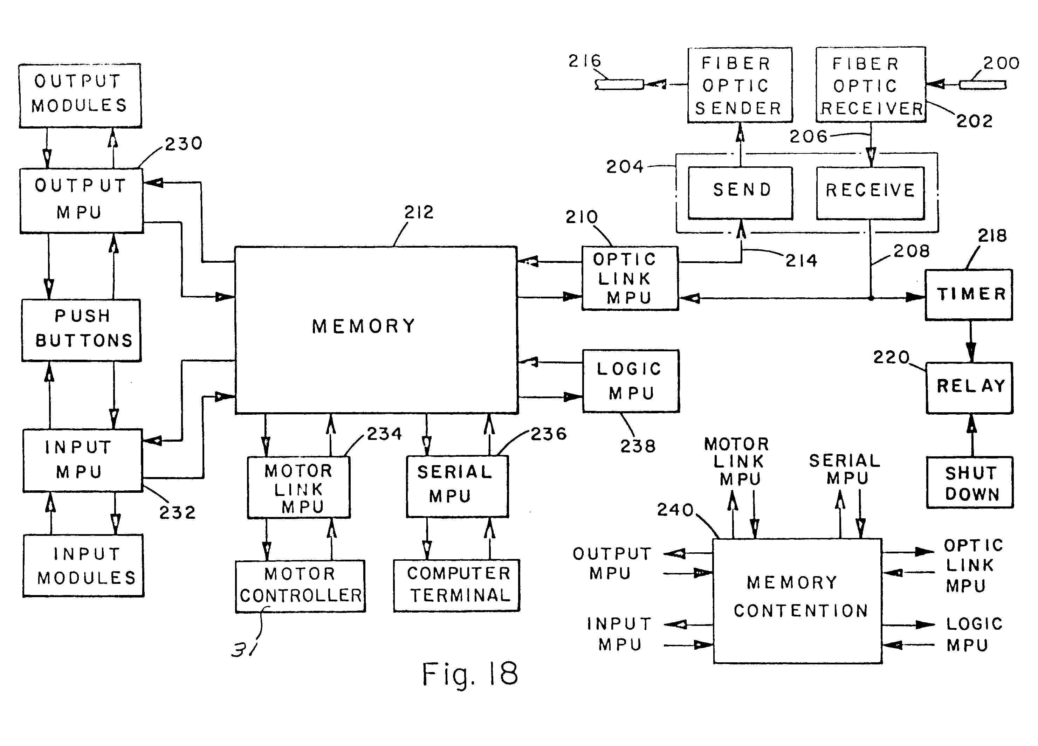

The program in logic module 17 may include certain other instructions. For instance, logic module 17 may transmit a command through fiber optic link 34 to motor controller 31 to carry out other steps, such as move a machine slide to a predetermined position at rapid speed, move the slide to a second position at work speed, and return the slide to the starting position. Pursuant to its program, the controller 31 activates machine slide motor 35 to move the machine slide according to the plan, and reports its movements via encoder 30 back to the motor controller. The results of the program are reported through fiber optic cable 36 to logic module 17. Information regarding programmed operation is reported by logic module 17 through fiber optic link 15 onto the loop 11. Thus, all signal communications to and from logic module 17 are accomplished through optical links 15, 27, 37 and 43. Logic module 17 is magnetically coupled to power module 23 carried by backplane 19. There are no electrical connections between them, as best seen in Figures 3 and 4. Magnetic coupling transformer 25 (FIGS. 1 and 4) on logic module 17 has a ferrite magnetic core 47, which is suitably connected to elements (FIG. 18) in the logic module requiring power (now shown in detail). Power module 23 on backplane 19 likewise includes a coupling transformer having a ferrite magnetic core 51 (FIG. 3) which is suitably connected to power source 29 (FIG. 1). When logic module 17 and power module 23 are assembled on backplane 19, ferrite cores 47 and 51 closely abut to transfer power electromagnetically from the power source to the logic module. No electric wires are involved in this coupling.

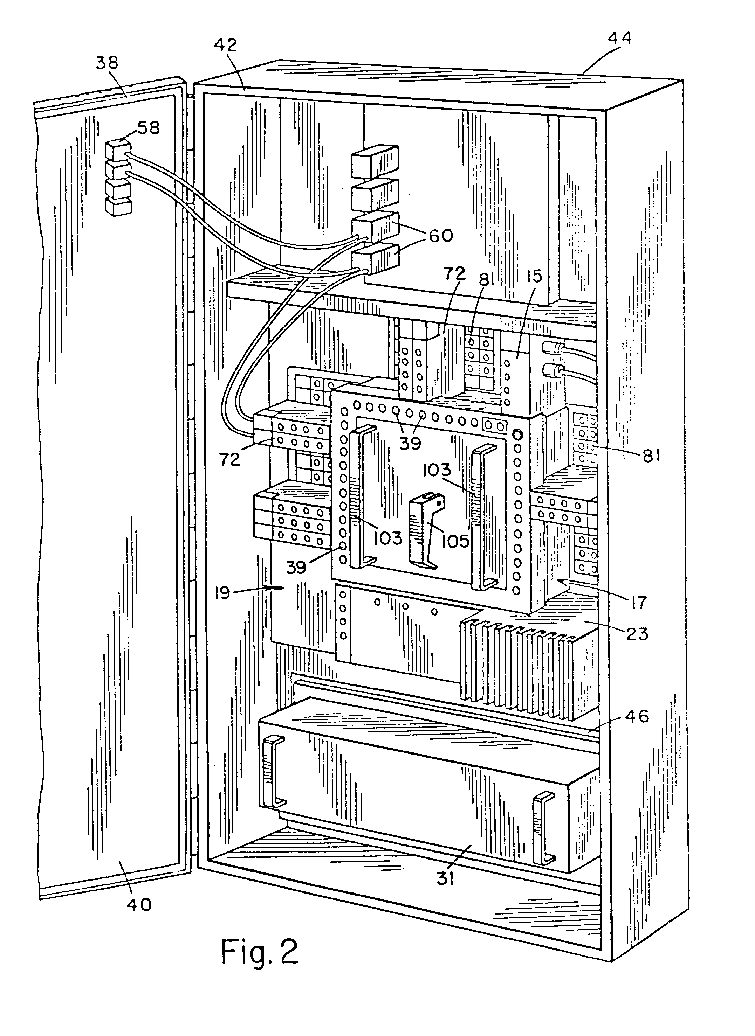

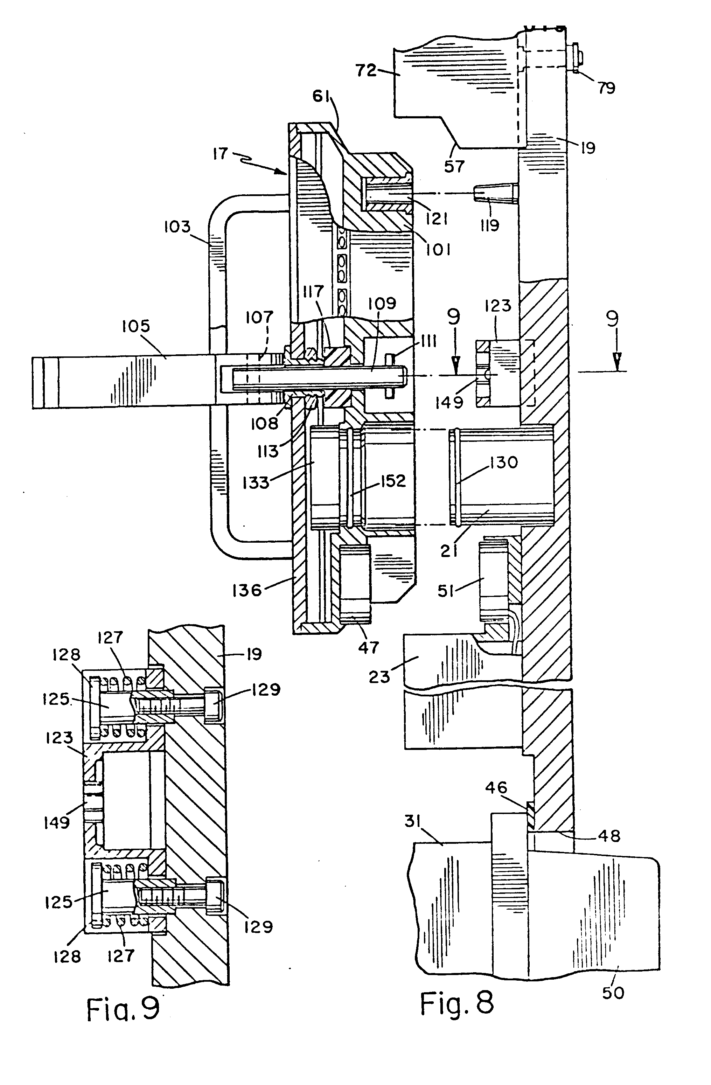

Figure 2 is a pictorial representation of the control device shown schematically in Figure 1. A flexible seal 38 is located inside the door 40 of the control box 44 to seal with the edge 42 of box 44 when the door is closed. A seal 46 (FIGS. 2 and 8) is positioned on the backplane 19 around the opening 48 (FIG. 8) in the backplane to seal opening 48 when the heat sink 50 (FIG. 8) from the motor controller 31 is inserted through opening 48 and motor controller 31 is attached in place by suitable means such as cap screws (not shown). Threaded receptacles 81 (Figure 3) on backplane 19 accept I/O modules for screw connection, as explained later in detail. Pushbuttons 58 are mounted on door 40 (Figure 2) and are electrically connected to relays 60 on the back of the control box. Relay 60 is connected to an I/O module 72 carried by backplane 19.

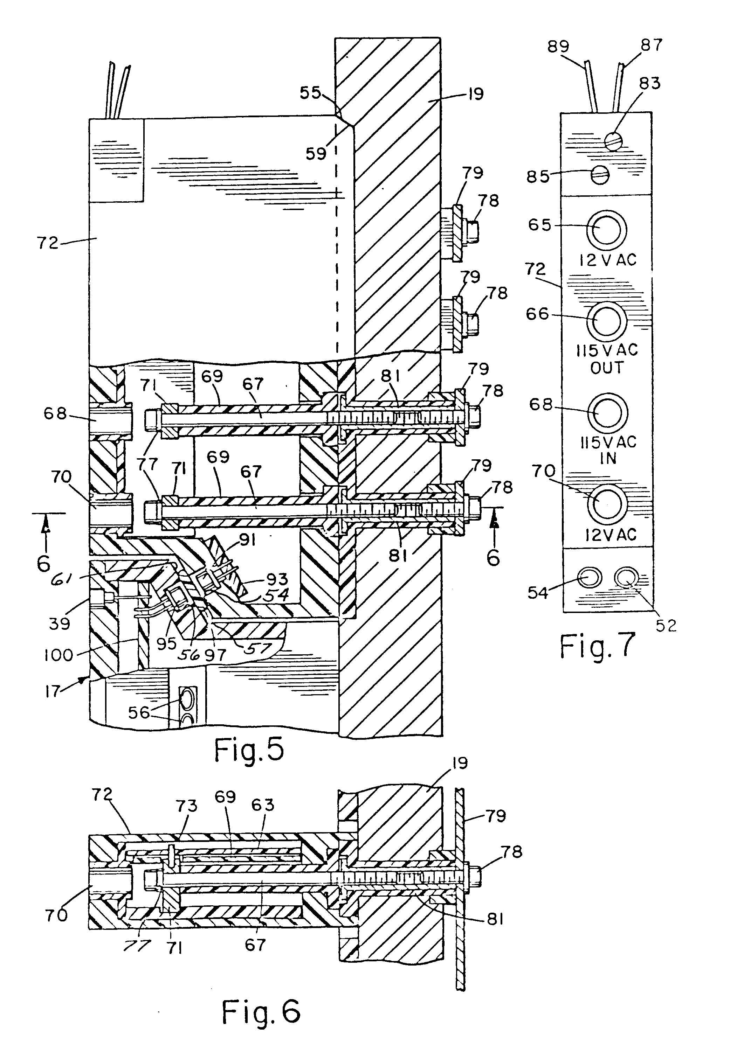

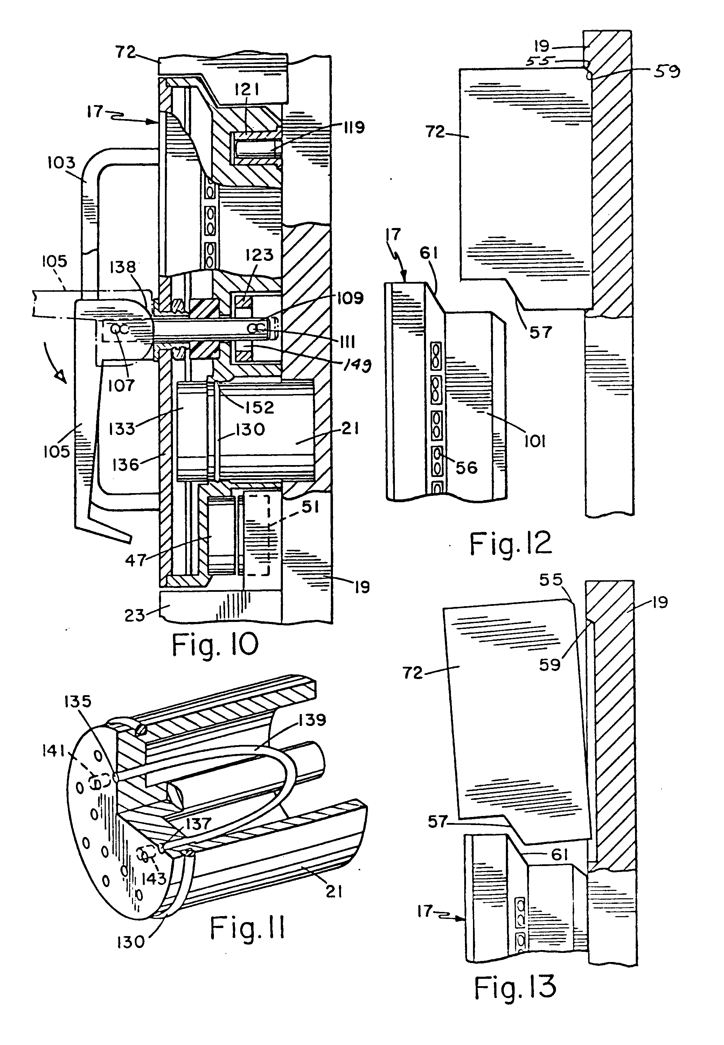

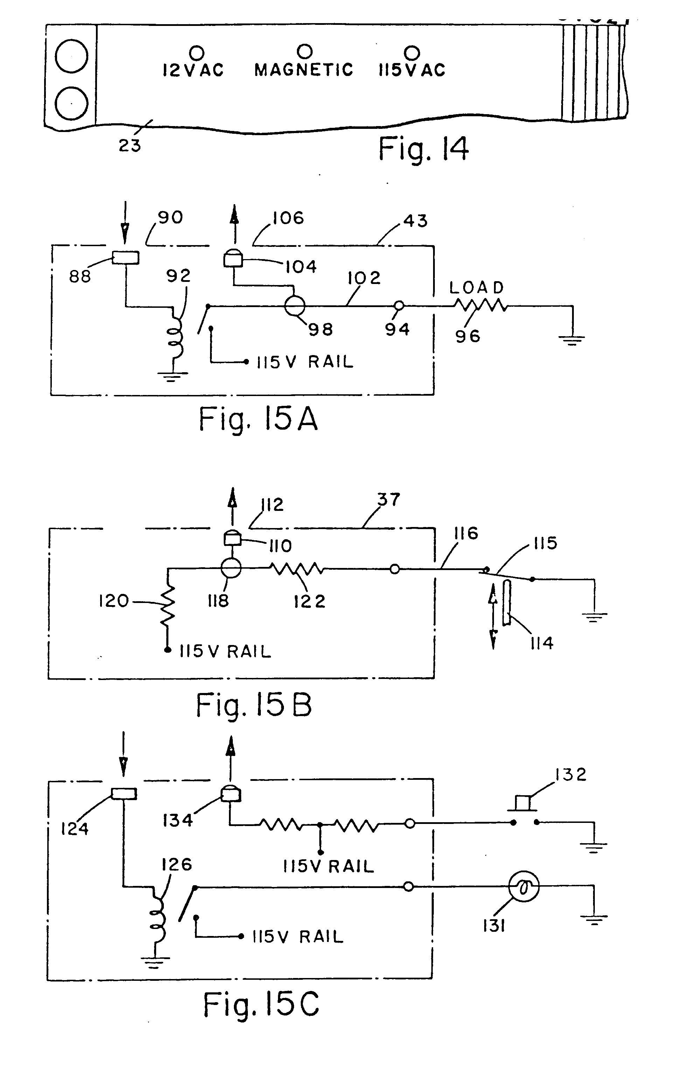

Figures 5-7 show the details of an input/output (I/O) module 72, with Figure 5 showing the I/O module and the logic module 17 joined. As will be explained in detail hereinafter, an I/O module 72 may be configured as an input module 37 (FIGS. 1 and 15B), as an output module 43 (FIGS. 1 and 15A), or as a pushbutton I/O module (FIG. 15C). Openings 52 and 54 in I/O module 72 align in assembly with a pair of openings 56 (Figure 4) in module 17. The face of the logic module 17 preferably includes legends such as "A, B, C, D . . ." to identify the location for the particular I/O module 72. Referring to Figures 12 and 13, each I/O module 72 has cam surface 55 and 57 (FIGS. 5, 12 and 13). These cam surfaces mate with cam surfaces 59 and 61 on backplane 9 and logic module 17 respectively. These cam surfaces permit the logic module and I/O module to be attached to and removed from backplane 19 without any required sequence. If I/O modules are attached to backplane 19 as shown in Figure 12, logic module 17 is positioned with cam surface 61 against cam surface 57, and the logic module is tightened into place. If logic module 17 is attached first as shown in Figure 13, cam surfaces 57 and 61 are engaged, and the I/O module is rotated to engage cam surface 55 with cam surface 59. The I/O module is removed by reversing the procedure.

Optical communication means, such as LED's or photosensors, are mounted within module 17 adjacent to at least some of the openings 56. One such element 95 is illustrated in FIG. 5. Each I/O module 72 has at least one optical communication means, such as photosensors or LED's, carried adjacent to an opening 52 or 54. Again, one such element 91 is illustrated in FIG. 5. Thus, with openings 52, 54 in each module 72 aligned with an associated pair of openings 56 in logic module 17, the respective elements 91, 95 are aligned and may optically communicate with each other. Element 95 is connected within logic module 17 to a circuit board 100. Loop 39 is also connected to circuit board 100. Optical element 91 is soldered to a riser 93 on the printed circuit board 63 (FIG. 6)in the I/O module. Optical element 91 aligns with a complementary optical element 95 in logic module 17. A clear, compliant silicone seal 97 is affixed to and encircles surface 61 of I/O module 17 covering openings 56, and is compressed against surface 57 of I/O module 72 over openings 54 when logic module 17 is assembled to backplane 19. The seal is compressed to squeeze moisture out as the I/O module is assembled in place. Cam surfaces 55 and 59 draw optical elements 91, 95 into alignment as the I/O module is connected.

Figure 5 and 6 show I/O module 72 fastened to backplane 19, the arrangement being typical at each module position. The I/O module includes printed circuit board 63 (FIG. 6). Screw holes 65, 66, 68 and 70 are provided for access to mounting screws 67. Each mounting screw 67 is mounted inside a tube 69 and extends through a copper block 71 that has a connecting pin 73 soldered to circuit board 63. A spring washer 77 is positioned between block 71 and the head of screw 67. A plurality of copper rails 79 are mounted on the back of backplane 19 and are fastened by screws 78 to associating brass receptacles 81. Each screw 67 extends through the I/O module and screws into the front of an associated receptacle 81. Thus, the screws 67 not only fasten the I/O module in place, but also connect circuit board 63 with rails 79. Epoxy is poured over printed circuit board 63. The four holes 65, 66, 68 and 70 thus provide access to the four electric buses or rails 79 on the back of backplane 19. These rails are identified as "12 V. A.C.", "115 V. A.C. OUT, "115 V. A.C. IN" and "12 V. A.C." on the I/O module surface adjacent to the screwholes 65-70, as shown in Figure 7. Screws 83 and 85 fasten the ends of wires 87 and 89 to module 72. Wires 87, 89 are screw-connected to electrically operated devices, such as clamp solenoid 45 and limit switch 41 in FIG. 1. The screws 67 inserted into openings 65 and 70 connect printed circuit board 63 to backplane 19 to provide a twelve volt peak-to-peak square wave that is connected to a transformer and rectifier (not shown) on the printed circuit board in each I/O module to supply five volts d.c. for powering the I/O module. Two 115 volt a.c. rails 79 (FIGS. 5-7) afford independent control, one for power out to devices and one for power to devices which will send signals into logic module 17. This makes it possible to check all inputs with no power going out, and to check outputs without tripping limit switches, etc.

Each I/O module 72 may be either an input module, an output module or both. Figure 15A is a schematic diagram of an output version 43 of the I/O module. An optical receiver 88 is aligned with the opening 90 in the body (which may be either opening 52 or 54) for receiving an optical signal from an aligned openings 56 in the logic module. When a beam of light is transmitted to receiver 88 from the logic module, the light energizes a relay 92 to close a circuit to the connector 94. Connector 94 is connected to a load 96, such as a clamp solenoid (FIG. 1) for example. A circuit sensing element 98 detects the flow of current in the wire 102. Sensing element 98 energizes the LED 104 which sends light through opening 106 into an aligned opening 56 in the logic module. This signal lights a lamp 39 (Figures 1 and 5) on the face of the logic module adjacent to the I/O module to indicate that it is active. Thus, if there is a loose wire on a terminal in the circuit so that the circuit is not conducting when the light beam from the logic module is turned on and the relay is actuated, it can be observed by viewing indicator lamp 39 on the logic module. The lamp will only be on when current is flowing.

An I/O module 37 containing an input circuit is shown in FIG. 15B. A light transmitter 110 aligns with opening 112 in the module. This opening aligns with an opening 56 and an optical receiver in the logic module (not shown). A limit switch 115 (which corresponds to limit switch 41 in FIG. 1) is activated by a slide finger 114. Limit switch 115 is connected by wire 116 to an input circuit that includes light transmitter 110, a current sensor 118, the resistors 120 and 122, and a connection to the 115 volt rail 79. When the limit switch is closed, the light transmitter 110 transmits a light beam corresponding to a corresponding receiver in logic module 17. The receiver stores this information in memory and also lights an indicator lamp 39 on the face of logic module 17. When the limit switch opens, the beam of light is turned off. This is input information to the logic module.

Figure 15C is a schematic diagram of an I/O module used with a pushbutton 132 (which corresponds to pushbuttons 58 in FIG. 2). An optic receiver 124 receives light pulses from the logic module (not shown) and energizes relay 126 which pulses a lamp 131. This lamp can be inside or adjacent to pushbutton 132. The flashing light indicates that the operation represented by the pushbutton is a valid operation and may be selected at this point in time. Thus, the operator knows that if he presses this button, he can initiate this operation. When the operator presses pushbutton 132, he closes the circuit to LED 134. This information is transmitted to a light receiver in the logic module (not shown), and the logic module now energizes relay 126 with a steady light beam so that lamp 131 produces a steady light to show that the operation has been initiated. Thus, the operator can look at the pushbutton panel and know which operations are in effect (steady light), which operations he can initiate (flashing light), and which operations are unavailable (no light). This same arrangement can be applied to limit switches, if desired, by placing lamps adjacent the limit switches.

FIGS. 8, 9 and 12 show logic module 17 positioned for insertion onto the backplane 19, and FIG. 10 illustrates completion of such assembly. Logic module 17 includes a body 101 with a pair of hand grips 103 extending from the face for gripping when attaching the logic device onto the backplane or removing it from the backplane. Hand grips 103 are positioned one on each side of a lock lever 105. Lock lever 105 is bifuracted and pivotally connected at 107 to a pin 109 which extends through a threaded barrel 108. A nut 113 is threaded onto barrel 108 to hold lock lever 105 onto the logic module back cover 136. Logic module cover 136 is affixed to logic module body 101 by suitable means, such as cap screws. Pin 109 extends through the body of the logic module and has an orthogonal lock finger 111 near its free end remote from lever 105. The bifuracted end of lock lever 105 includes a rounded cam 138 for riding on the face of logic module cover 136. A sealing ring 117 surrounds pin 109 and seals the interior of the logic module. Four tapered pins 119 are positioned on backplane 19 for seating in tapered seats 121 in logic device body 101.

A lock housing 123 is mounted on backplane 19. Near each end of the face of the lock housing, a pin 125 extends into the lock housing and has a hollow threaded interior. A spring 127 surrounds each pin 125 and extends between the head 128 of pin 125 and the back wall of lock housing 123. A threaded fastener 129 is screwed into the pin 125 and holds lock housing 123 against backplane 19. Logic module 17 is connected to backplane 19 by inserting logic module seats 121 over pins 119 with lock lever 105 in the position shown in Figure 8 and lock finger 111 extending vertically. Lock finger 111 is inserted through a central keyhole opening 149 in housing 123, and lock lever 105 is rotated ninety degrees about the axis of pin 109 to the phantom position shown in Figure 10 so that finger 111 is orthogonal to the axis of opening 149. Lock ever 105 is then pivoted downward about pin 107 with cam surface 138 engaging the face of logic module cover 136. This action pulls finger 111 against the front wall of lock housing 123, and pulls the back wall of the lock housing against spring 127 to lock logic module 17 onto backplane 19. The logic module is removed from the backplane by reversing this procedure.

Personality module 21 (FIGS. 1, 3, 8 and 10-11) is affixed to backplane 19 and is a permanent part of the station. It abuts and is aligned in assembly with a personality module accommodater 133 (FIGS. 4, 8 and 10) in logic module 17. A sealing ring 130 is positioned on the personality module 21 for seating in a groove 152 (FIG. 10) in logic module 17. The personality module detail is shown in Figure 11, with an LED 141 and an optical detector 143 in the logic module accommodater 133 being shown in phantom. Eight openings 135 are arranged in an inner circle, and eight openings 137 are arranged in an outer circle, in the face of the personality module. A similar arrangement is provided on personality module accommodater 133 on logic module 17 (Figure 4), with LEDs 141 in the inner circle of openings and optical detectors 143 in the outer circle of openings. A light pipe 139 connects each inner opening 135 with a particular outer opening 137 to provide a unique pattern or number for the module station.

The LEDs 141 in the logic module serially flash light pulses around the inner circle of openings 135. The optical detectors 143 in logic module 17 indicate which outer opening is connected by light pipes 139 to which inner opening, and this information is serially fed back to the logic module to indicate its unique pattern or number. The logic module serially turns the LEDs on one at a time and then scans all eight detectors in the outer circle. The logic module can then report its identity to communications loop 11 (Figure 1) through optical link 15. If the logic module sees no light or more than one light during a scan, it knows there is an error and shuts the system down. The embodiment shown uses an eight-opening pattern, but other numbers can be used. Other (prior art) approaches to station identification just look and cannot tell if the identifier is in error as long as it sees an identifier.

Testing is quickly and easily accomplished according to the following procedure:

Figure 14 shows indicating lamps on the front of the power module 23 that indicate the state of the 12 volt a.c. power, the magnetic coupling of the power supply to the logic module, and the 115 volt a.c. line voltage. If a problem arises, the lamps are visually checked. If the power supply indicating lamps show that all power is intact, then the indicating lamps on the face of the logic module are visually inspected. If one of these indicating lamps should be on but is not, then further investigation is required.

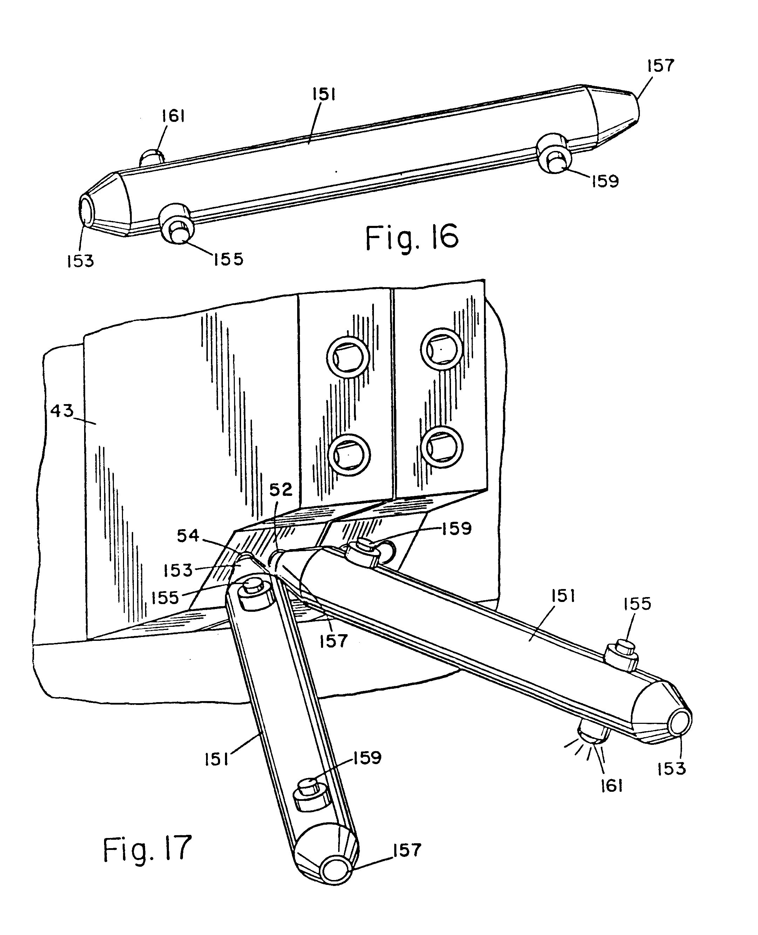

Figure 16 shows a testing device 151. One end of the testing device includes an opening 153 that communicates with a light transmission element inside the testing device. A push button 155 turns the light transmission element on and off. Testing device 151 also includes an opening 157 at the other end that communicates with a light sensing element inside the testing deice. A push button 159 actuates the light sensing device. If light is received, the lamp 161 is turned on to show this condition.

Figure 17 illustrates two testing devices 151 used in checking an output module 43. (Logic module 17 has been removed from its position adjacent the I/O modules.) Button 155 is depressed and light is emitted from opening 153 in the testing device into opening 54 in output module 43 (corresponding to opening 90 in FIG. 15A). A second testing device 151 is held with its opening 157 adjacent to opening 52 in the output module (corresponding to opening 106 in FIG. 15A.) Button 159 on the second testing device is depressed. If the circuit shown in Figure 15A is operating correctly, lamp 161 on the second testing device will be lit. An input module 37 with the circuit shown in Figure 15B is tested by placing the opening 157 in a testing device 151 adjacent to the opening 112 in the module, and by then pressing button 159. Limit switch 115 (Figure 15B) is closed by hand or a push button. If the circuit of module 37 is operating properly, indicating lamp 161 on testing deice 151 is lit.

Figure 18 is a functional block diagram of logic module 17. The input of light pulses from optical loop 11 (Figure 1) enters via the fiber optic cable 200 and is fed through fiber optic receiver 202 via line 206 into the receive portion of a chip 204, which can be an 8250 for example. The input travels via character received line 208 to an optical link MPU 210, which can be a Zilog Z80 or any one of may other well known microprocessors. MPU 210 interfaces with memory 212, which is preferably a non-volatile bubble memory that will accept either read or write instructions. The input is stored in memory, and may be recalled and processed further by the microprocessor. MPU 210 communicates as required via line 214 with the send portion of chip 204 where information in the form of light pulses is sent via line 216 back onto the optic loop 11 of Figure 1. Memory 212 also stores the operating program for the work station. A pulse driven timer 218 is connected to character received line 208 and is also connected to a solid state watch dog relay 220. As long as light pulses are being sent along line 208 every ten milliseconds, the system continues to function. When a ten millisecond time period has passed with no received character passing through line 208, pulse driven timer 218 pulls out the watch dog and shuts the system down.

Memory 212 is a public memory that is available to the several MPUs illustrated. An output MPU 232 communicates with memory 212 and the output modules. An input MPU 232 communicates with memory 212 and the input modules. The pushbuttons communicate with the output and input MPUs. A motor link MPU 234 communicates with memory and the motor controller. A serial MPU 236 communicates with memory and a computer terminal. A logic MPU 238 communicates with memory and executes the logic for operating the machine. These MPUs may be Z80s or any one of many well known microprocessors. Output MPU 230 and input MPU 232 communicate with the personality module to establish identity when the system is first powered up. When identity is established, they switch to communication with the input modules and output modules.

Since several MPUs have access to the same memory, it is necessary to organize memory access. This is done with a memory contention chip 240. In the present instance, it has been done with a PAL (programmable array logic) chip sold by MMI, Model 20X10. Chip 240 is programmed in conventional fashion whereby each MPU communicates with chip 240 via a memory request line and an access granted line. Chip 240 includes a priority assignment whereby the highest priority is assigned to the lowest numbered MPU. In this case, optic link MPU 210 is assigned the number 1 and has the highest priority. Serial MPU 236 is assigned the number 2. Motor link MPU 234 is assigned the number 3. Output module MPU 230 is assigned the number 4. Input module MPU 232 is assigned the number 5. Logic module MPU 238 is assigned the number 6.

The control device of the present invention is sealed against contamination and is protected against electrical noise from an industrial environment. All signal coupling is through optic links. There are no sliding contacts. All power coupling is through attachment screws or magnetic coupling.

## Claims

1. A control station, which includes station support structure (19), station logic module means (17) capable of receiving or generating optical signals, said logic module means including means (105, 107, 109, 111) for removeable mounting said logic module means to said support structure, and means on said support structure and said logic module means for transmitting communication signals on optical communication lines (11, 13, 34, 36) to and from said logic module means for conducting controlled operations at said station characterized in that said means for transmitting communication signals comprises first optical coupling means (72, 91) mounted on said support structure (19) and connected to said optical communication lines (11, 13, 34, 36) to allow transmission of communication signals between said support structure (19) and said communication lines (11, 13, 34, 36) and second optical coupling means (95) carried by said logic module means (17) to allow transmission of communication signals to and from said logic module means without physical contact between said logic module means and said optical communication lines.

2. The control station set forth in claim 1, further comprising means (119, 121) on said support structure (19) and on said logic module means (17) for aligning said first and second optical coupling means (72, 91, 95) when said logic module means is assembled to said support structure.

3. The control station set forth in claim 1 or 2 further comprising power module means (23) on said support structure (19) and means coupling power from said power module means to said logic module means (17), characterized in that said power-coupling means comprises first electromagnetic coupling means (51) mounted on said support structure and second electromagnetic coupling means (25) carried by said logic module means, said aligning means (119, 121) functioning to align said first and second electromagnetic coupling means (51, 25) in assembly such that power is supplied to said logic module means (17) from said power module means (23) without direct electrical connection therebetween.

4. The control station set forth in claim 1, 2 or 3 wherein said support structure (19) comprises a backplane having a multiplicity of module mounting positions, and wherein said first optical coupling means (72) comprises I/O modules mounted to said backplane in selected ones of said module positions.

5. The control station set forth in claim 4 wherein said backplane (19) includes a plurality of I/O power busses (79), and wherein said I/O modules (72) include means (67, 71, 73) for simultaneously removably mounting said I/O modules to said backplane (19) and obtaining electrical connection to said I/O power busses (79).

6. The control station set forth in claim 5 further comprising opposing cam surface pairs (59, 55 and 57, 61) on said backplane (19) and said I/O modules (72), and on said I/O modules (72) and said logic module means (17) for permitting removal of I/O module means from said backplane with said logic module means assembled thereto while simultaneously cooperating with said means (119, 121) for aligning said optical and electromagnetic coupling means.

7. A control station which includes station support structure (19), station logic module means (17) capable of receiving or generating optical signals, said logic module means including means (105, 107, 109, 111) for removeable mounting said logic module means to said support structure, and means on said support structure and said logic module means for transmitting communication signals on optical communication lines (11, 13, 34, 36) to and from said logic module means for conducting controlled operations at said station characterized by:
means on said support structure (19) for identifying station character to said logic module means (17) comprising one optical coupling means (21) carried by said support structure and other optical coupling means (133) carried by said logic module means, said station character identifying means functioning such that information regarding station character is conveyed to said logic module means (17) without direct electrical connection to said logic module means.

8. The control station set forth in claim 7, further comprising means (119, 121) on said support structure (19) and on said logic module means (17) for aligning the said one and said other optical coupling means when the logic module means is assembled to said support structure.

9. The control station set forth in claim 7 wherein said one optical coupling means (21) comprises first and second series of optical apertures (135, 137) and optical transmitting means (139) selectively connecting apertures (135) of said first series to apertures (137) of said second series, and wherein said other optical coupling means (133) comprises optical transmitting means (141) on said logic module means (17) for alignment with said first series of apertures (135) and optical receiving means (143) on said logic module means for alignment with said second series of apertures (137).

10. The control station set forth in any preceding claim characterized in that said removable mounting means comprises a housing (123) mounted on said support structure (19), said housing including a keyhole aperture (149), a shaft (109) rotatably carried on said logic module means (17) and including reception means (111) at one end for reception into said aperture (149), and means (105) for rotating said shaft (109).

11. The control station set forth in claim 10 wherein said removable mounting means further comprises resilient means (127) biasing said housing (109) against support structure (19), and means (107, 138) on said rotating means (105) for drawing said shaft (109) and said reception means (111) against said housing (123) against said resilient means (127).

## Revendications

1. Poste de commande qui comporte une structure (19) de support de poste, un module logique (17) de poste capable de recevoir ou de créer des signaux optiques, le module logique comportant un dispositif (105, 107, 109, 111) destiné au montage amovible du module logique sur la structure de support, et un dispositif placé sur la structure de support et le module logique et destiné à transmettre des signaux de communication par des lignes optiques de communication (11, 13, 34, 36) vers le module logique et à partir de celui-ci afin que des opérations commandées soient réalisées audit poste, caractérisé en ce que le dispositif destiné à transmettre des signaux de communications comporte un premier dispositif (72, 91) de couplage optique monté sur la structure de support (19) et connecté aux lignes optiques (11, 13, 34, 36) de communication afin que les signaux de communication puissent être transmis entre la structure de support (19) et les lignes de communication (11, 13, 34, 36), et un second dispositif (95) de couplage optique porté par le module logique (17) et destiné à permettre la transmission de signaux de communication au module logique et à partir de celui-ci, sans contact physique entre le module logique et les lignes optiques de communication.

**2.** Poste de commande selon la revendication 1, comprenant en outre un dispositif (119, 121) monté sur la structure de support (19) et sur le module logique (17) et destiné à aligner le premier et second dispositif de couplage optique (72, 91, 95) lorsque le module logique est assemblé sur la structure de support.

**3.** Poste de commande selon la revendication 1 ou 2, comprenant en outre un module de puissance (23) placé sur la structure de support (19) et un dispositif destiné à coupler de l'énergie du module de puissance au module logique (17), caractérisé en ce que le dispositif de couplage d'énergie comporte un premier dispositif (51) de couplage électromagnétique monté sur la structure de support et un second dispositif (25) de couplage électromagnétique porté par le module logique, le dispositif d'alignement (119, 121) assurant l'alignement du premier et du second dispositif (51, 25) de couplage électromagnétique dans l'ensemble afin que l'énergie soit transmise au module logique (17) à partir du module de puissance (23) sans connexion électrique directe entre aux.

**4.** Poste de commande selon la revendication 1, 2 ou 3, dans lequel la structure de support (19) comporte un fond de panier ayant de nombreuses positions de montage de module et dans lequel le premier dispositif (72) de couplage optique comporte des modules d'entrée-sortie montés sur le fond de panier à des positions choisies de module.

**5.** Poste de commande selon la revendication 4, dans lequel le fond de panier (19) comporte plusieurs bus d'alimentation (79) d'entrée-sortie, et dans lequel les modules d'entrée-sortie (72) comportent un dispositif (67, 71, 73) assurant le montage amovible simultané des modules d'entrée-sortie sur le fond de panier (19) et la réalisation de connexions électriques aux bus d'alimentation (79) d'entrée-sortie.

**6.** Poste de commande selon la revendication 5, comprenant en outre des paires opposées (59, 55 et 57, 61) de surfaces de cames placées sur le fond de panier (19) et les modules d'entrée-sortie (72), et sur les modules d'entrée-sortie (72) et le module logique (17) afin qu'elles permettent l'extraction des modules d'entrée-sortie du fond de panier avec le module logique qui est monté sur eux, avec coopération simultanée avec le dispositif (119, 121) d'alignement des dispositifs de couplage optique et électromagnétique.

**7.** Poste de commande qui comprend une structure (19) de support de poste, un module logique (17) de poste capable de recevoir ou de créer des signaux électriques, le module logique comprenant un dispositif (105, 107, 109, 111) de montage amovible du module logique sur la structure de support et un dispositif placé sur la structure de support et le module logique et destiné à transmettre des signaux de communication par des lignes optiques (11, 13, 34, 36) de communication vers le module logique et à partir de celui-ci afin que des opérations commandées soient réalisées au poste, caractérisé par un dispositif placé sur la structure de support (19), destiné à identifier un caractère de poste pour le module logique (17) et comprenant un dispositif (21) de couplage optique porté par la structure de support et un autre dispositif (133) de couplage optique porté par le module logique, le dispositif d'identification de caractère de poste ayant un fonctionnement tel que l'information relative au caractère de poste est transportée vers le module logique (17) sans connexion électrique directe au module logique.

**8.** Poste de commande selon la revendication 7, comprenant en outre un dispositif (119, 121) placé sur la structure de support (19) et sur le module logique (17) et destiné à aligner le premier dispositif de couplage optique et l'autre dispositif de couplage optique lorsque le module logique est assemblé sur la structure de support.

**9.** Poste de commande selon la revendication 7, dans lequel le dispositif (21) de couplage optique comprend une première et une seconde série d'ouvertures optiques (135, 137) et de dispositifs de transmission optique (139) connectant sélectivement les ouvertures (135) de la première série à des ouvertures (137) de la seconde série, et dans lequel l'autre dispositif (133) de couplage optique comporte des dispositifs (141) de transmission optique, montés sur le module logique (17) et destinés à être alignés sur la première série d'ouvertures (135), et un dispositif de réception optique (143) monté sur le module logique et destiné à être aligné sur la seconde série d'ouvertures (137).

**10.** Poste de commande selon une quelconque des revendications précédentes, caractérisé en ce que le dispositif de montage amovible comprend un boîtier (123) monté sur la structure de support (19), le boîtier comportant une ouverture (149) en trou de serrure, un arbre (109) porté sur le module logique (17) de manière qu'il puisse tourner et comprenant un dispositif (111) placé à une première extrémité et destiné à se loger dans l'ouverture (149), et un dispositif (105) destiné à faire tourner l'arbre (109).

11. Poste de commande selon la revendication 10, dans lequel le dispositif de montage amovible comporte en outre un dispositif élastique (127) rappelant le boîtier (109) contre la structure de support (19) et un dispositif (107, 138) placé sur le dispositif (105) d'entraînement en rotation et destiné à tirer l'arbre (109) et le dispositif de réception (111) contre le boîtier (123) malgré la force du dispositif élastique (127).

## Patentansprüche

1. Steuerungsanlage mit einem Träger (19), einem logischen Modulbauteil (17) zum Empfangen bzw. Erzeugen optischer Signale, wobei der Modulbauteil Mittel (105, 107, 109, 111) zum lösbaren Befestigen des Modulbauteils am Träger aufweist und mit Mitteln an dem Träger und dem Modulbauteil zum Übertragen von Kommunikationssignalen auf optischen Übertragungsleitungen (11, 13, 34, 36) zu und von dem Modulbauteil zum Ausführen von Steuervorgängen in der Steuerungsanlage, dadurch gekennzeichnet, daß die Mittel zum Übertragen der Kommunikationssignale erste optische Koppler (72, 91) aufweisen, die an dem Träger (19) befestigt und an die optischen Übertragungsleitungen (11, 13, 34, 36) zur Übertragung der Kommunikationssignale zwischen dem Träger (19) und den Übertragungsleitungen (11, 13, 34, 36) angeschlossen sind, sowie zweite optische Koppler (95) aufweisen, die an dem logischen Modulbauteil (17) angeordnet sind und die Übertragung der Kommunikationssignale zu und von dem logischen Modulbauteil ohne physikalischen Kontakt zwischen dem logischen Modulbauteil und den optischen Übertragungsleitungen ermöglichen.

2. Steuerungsanlage nach Anspruch 1, mit Mitteln (119, 121) an dem Träger (19) und an dem Modulbauteil (17) zum Ausrichten der ersten und zweiten optischen Koppler (72, 91, 95), wenn das logische Modulbauteil an dem Träger befestigt wird.

3. Steuerungsanlage nach Anspruch 1 oder 2, mit einem Leistungsmodulbauteil (23) auf dem Träger und Mittel zur Leistungsübertragung von dem Leistungsmodulbauteil zu dem logischen Modulbauteil (17), dadurch gekennzeichnet, daß die Mittel zur Leistungsübertragung erste, auf dem Träger befestigte elektromagnetische Koppler (51) und zweite, an dem logischen Modulbauteil angeordnete elektromagnetische Koppler (25) aufweisen, und daß die Mittel zum Ausrichten (119, 121) die ersten und zweiten elektromgnetischen Koppler (51, 25) bei der Montage derart ausrichten, daß von dem Leistungsmodulbauteil (23) Leistung zu dem logischen Modulbauteil (17) ohne unmittelbar elektrische Verbindung übertragbar ist.

4. Steuerungsanlage nach Anspruch 1, 2 oder 3, wobei der Träger (19) eine rückseitige Tragplatte mit mehreren Modulbefestigungspositionen aufweist, und wobei die ersten optischen Koppler (72) I/O Module aufweisen, die auf der Tragplatte in ausgewählten Modulpositionen befestigt sind.

5. Steuerungsanlage nach Anspruch 4, wobei die Tragplatte (19) mehrere I/O Leistungsschienen (79) aufweist und wobei die I/O Module (72) Mittel (67, 71, 73) aufweisen, mit deneng gleichzeitig die I/O Module an der Tragplatte lösbar befestigt und ein elektrischer Anschluß an die I/O Leistungsschienen (79) ermöglicht werden.

6. Steuerungsanlage nach Anspruch 5, mit Paaren von einander gegenüberliegenden Paßflächen (59, 55 und 57, 61) an der Tragplatte (19) und den I/O Modulen (72), sowie an den I/O Modulen (72) und dem logischen Modulbauteil (17) zum Lösen der I/O Module von der Tragplatte, wobei der logische Modulbauteil an dieser befestigt ist, wobei sie gleichzeitig mit den Mitteln (119, 121) zum Ausrichten der optischen und elektromagnetischen Koppler zusammenwirken.

7. Steuerungsanlage mit einem Träger (19), einem logischen Modulbauteil (17) zum Empfangen und Erzeugen optischer Signale, wobei das logische Modulbauteil Mittel (105, 107, 109, 111 usw.) der Steuerungsanlage mit einem Träger (19), einem logischen Modulbauteil (17) zum Empfangen bzw. Erzeugen optischer Signale, wobei der Modulbauteil Mittel (105, 107, 109, 111) zum lösbaren Befestigen des Modulbauteils am Träger aufweist und mit Mitteln an dem Träger und dem Modulbauteil zum Übertragen von Kommunikationssignalen auf optischen Übertragungsleitungen (11, 13, 34, 36) zu und von dem Modulbauteil zum Ausführen von Steuervorgängen in der Steuerungsanlage, gekennzeichnet durch Mittel an dem Träger (19) zum Identifizieren der Steuerungsanlage für das logische Modulbauteil (17), wobei ein an dem Träger angeordneter optischer Koppler (21) und ein anderer an dem logischen Modulbauteil angeordneter optischer Koppler (133) vorgesehen ist und die Identifikationsmittel derart wirken, daß die die Steuerungsanlage betreffende Information zu dem logischen Modulbauteil (17) ohne unmittelbare elektrische Verbindung zu dem Modulbauteil übertragen wird.

8. Steuerungsanlage nach Anspruch 7 mit Mitteln (119, 121) an dem Träger (19) und dem logischen Modulbauteil (17) zum Ausrichten der beiden optischen Koppler, wenn das Modulbauteil an dem Träger befestigt wird.

9. Steuerungsanlage nach Anspruch 7, wobei der optische Koppler (21) erste und zweite Reihen optischer Öffnungen (135, 137) und optische Übertrager (139) zur Verbindung bestimmter Öffnungen (135) der ersten Reihe mit Öffnungen (137) der zweiten Reihe aufweist, und wobei der andere optische Koppler (133) optische Übertrager (141) an dem logischen Modulbauteil (17) zum Ausrichten mit der ersten Reihe von Öffnungen (135) und optische Empfänger (143) an dem logischen Modulbauteil zum Ausrichten mit der zweiten Reihe von Öffnungen (137)aufweist.

10. Steuerunganlage nach einem der vorhergehenden Ansprüche, dadurch gekennzeichnet, daß die Mittel zum lösbaren Befestigen ein an dem Träger (19) befestigtes Gehäuse (123) mit einer Öffnung (149) für einen Schlüssel aufweisen, daß ein drehbarer an dem Modulbauteil (17) angeordneter Schaft (109) mit einer Verriegelung (111) an seinem Ende in die Öffnung (149) einsteckbar ist und Mittel (105) zum Drehen des Schaftes (109) vorgesehen sind.

11. Steuerungsanlage nach Anspruch 10, wobei die Mittel zum lösbaren Befestigen ferner Federn (127) zum Andrücken des Gehäuses (109) an den Träger (19) aufweisen und Mittel (107, 138) an den Mitteln (105) zum Drehen, um den Schaft (109) und die Verriegelung (111) an das Gehäuse (123) gegen die Federn (127) zu ziehen.

ORBITAL LOOP FIBER OPTICS

11

AC RETURN

OPTIC LINK MODULE

15

OUTPUT MODULE

43

INPUT MODULE

37

LOGIC MODULE

17

20

39

39

21

25

45

13

41

19

POWER MODULE

23

27

34

36

MOTOR CONTROLLER

31

33

ENC

30

MOTOR

35

POWER SOURCE

29

Fig. 1

Fig. 2

Fig. 3

Fig. 4

Fig.5

Fig.7

Fig.6

Fig. 9

Fig. 8

Fig. 10

Fig. 11

Fig. 12

Fig. 13

Fig. 14

Fig. 15 A

Fig. 15 B

Fig. 15 C

161 151 157

153 155 159

Fig. 16

43

52

54

153

155

159

157

151

155

151

159

161 153

Fig. 17 157

Fig. 18